Europäisches Patentamt

European Patent Office

Office européen des brevets

(19)

(11) **EP 1 321 973 A2**

(12) # EUROPEAN PATENT APPLICATION

(43) Date of publication:
**25.06.2003 Bulletin 2003/26**

(51) Int Cl.7: **H01L 21/28**, H01L 29/51

(21) Application number: **02102746.1**

(22) Date of filing: **12.12.2002**

(84) Designated Contracting States:
**AT BE BG CH CY CZ DE DK EE ES FI FR GB GR IE IT LI LU MC NL PT SE SI SK TR**
Designated Extension States:
**AL LT LV MK RO**

(30) Priority: **14.12.2001 US 341521**
**28.06.2002 US 184521**

(71) Applicant: **Texas Instruments Incorporated Dallas, Texas 75251 (US)**

(72) Inventors:
• **Colombo, Luigi**
  **75248, Dallas (US)**

• **Visokay, Mark R.**
  **75082, Richardson (US)**
• **Bevan, Malcolm J.**
  **75240, Dallas (US)**
• **Rotondaro, Antonio L.**
  **75206, Dallas (US)**

(74) Representative: **Holt, Michael et al**
**Texas Instruments Ltd.,**
**EPD MS/13,**
**800 Pavilion Drive**
**Northampton Business Park,**
**Northampton NN4 7YL (GB)**

(54) **CVD deposition of a metal-silicon-oxynitride gate dielectrics**

(57)     A method for forming a high-k gate dielectric film (106) by CVD of a M-SiN or M-SION, such as $HfSiO_2$. Post deposition anneals are used to adjust the nitrogen concentration.

FIG. 3

EP 1 321 973 A2

## Description

### FIELD OF THE INVENTION

The invention is generally related to the field of forming high dielectric constant (high-k) films in semiconductor devices and more specifically to forming metal-silicon-oxynitride gate dielectrics by chemical vapor deposition or atomic layer deposition.

### BACKGROUND OF THE INVENTION

As semiconductor devices have scaled to smaller and smaller dimensions, the gate dielectric thickness has continued to shrink. Although further scaling of devices is still possible, scaling of the gate dielectric thickness has almost reached its practical limit with the conventional gate dielectric material, silicon dioxide, and silicon oxynitride. Further scaling of silicon dioxide gate dielectric thickness will involve a host of problems: extremely thin layers allow for large leakage currents due to direct tunneling through the oxide. Because such layers are formed literally from a few layers of atoms, exacting process control is required to repeatably produce such layers. Uniformity of coverage is also critical because device parameters may change dramatically based on the presence or absence of even a single monolayer of dielectric material. Finally, such thin layers form poor diffusion barriers to dopants from polycrystalline silicon electrodes.

Realizing the limitations of silicon dioxide, researchers have searched for alternative dielectric materials which can be formed in a thicker layer than silicon dioxide and yet still produce the same field effect performance. This performance is often expressed as "equivalent oxide thickness": although the alternative material layer may be thicker, it has the equivalent effect of a much thinner layer of silicon dioxide (commonly called simply "oxide"). In some instances, silicon dioxide has been replaced with a SiON. However, even higher-k dielectrics will soon be needed. Some films currently being investigated include deposited oxides or nitrides such as ZrO2, ZrSiO, ZrSiON, HfO2, HfON, HfSiO, HfSiON, AlON, and AlZrO, HfAlO, YSiO, LaSiO, LaAlO, YalO etc.. Manufacturable processes for incorporating these materials into the CMOS flow are needed.

### BRIEF DESCRIPTION OF THE DRAWINGS

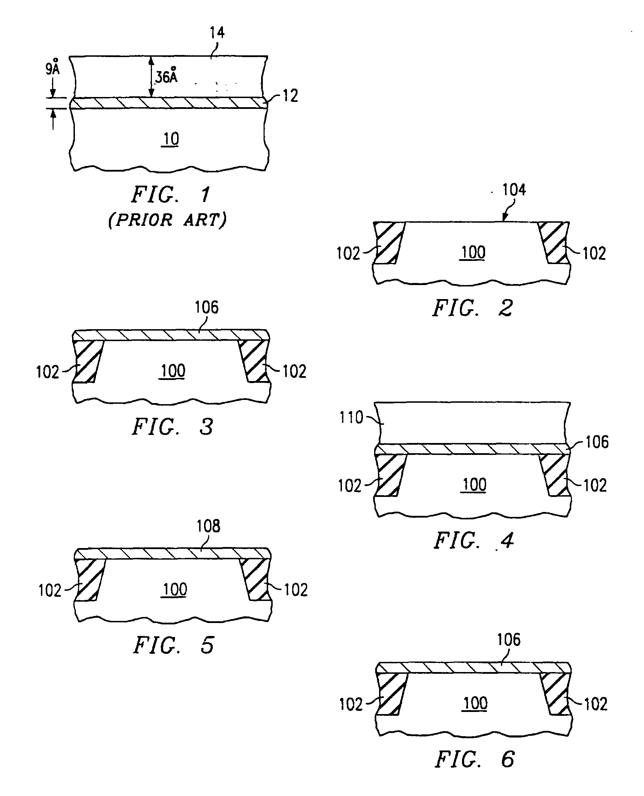

In the drawings:
FIG. 1 is a cross-sectional diagram of a HfSiO2 gate dielectric with an interfacial oxide formed according to the prior art; and
FIGs. 2-6 are cross-sectional diagrams of a high-K gate dielectric formed according to an embodiment of the invention at various stages of fabrication.DETAILED DESCRIPTION OF THE EMBODIMENTS
One particularly desirable class of high-k films is the metal-silicon-oxides ($MSiO_2$), where the metal is Hf, Zr, La, Y, etc. Unfortunately, when a $MSiO_2$ such as $HfSiO_2$ 14 is deposited by CVD an interfacial oxide (silicon dioxide) 12 forms at the interface between the substrate 10 and the $HfSiO_2$, as shown in Fig. 1. The Si/O rich interface prevents scaling below ~1.5nm.

One possible solution is nitridation of the Si substrate surface. Nitridation of the surface is very effective in minimizing the oxidation of the Si substrate during the initial stages of deposition. However, nitridation of the Si substrate surface gives rise to a high interfacial trap density and low minority carrier mobility.

The current invention provides a method for forming a high-k dielectric without a $SiO_2$ interfacial layer. Embodiments of the invention deposit MSiON or MSiN by CVD directly on the Si substrate surface. Post deposition anneals are then used to adjust the nitrogen concentration and to anneal out defects.

A first embodiment of the invention will now be described in conjunction with a method for forming a MOSFET transistor. Referring to FIG. 2, a semiconductor body 100 is processed through the formation of isolation structures 102 and any desired channel or threshold adjust implants. Semiconductor body 102 typically comprises a silicon substrate with or without additional epitaxial layers formed thereon as is known in the art.

The surface 104 of semiconductor body 100 is preferably a clean, oxide free surface. In addition, the surface 104 may be hydrogen terminated. Methods for providing such a surface are known in the art. U.S. Patent No. 6,291,867, issued 9/18/01 assigned to Texas Instruments Incorporated and incorporated herein by reference describes several methods for providing such a surface.

A MSiON gate dielectric 106 is deposited by CVD on the surface of semiconductor body 102, as shown in FIG. 3. MSiON gate dielectric 106 may, for example, comprise HfSiON, ZrSiON, LaSiON, YSiON, GdSiON, EuSiON, or PrSiON. Including nitrogen in the CVD deposition prevents or at least minimizes the formation of an interfacial oxide. The deposition process may be a thermal CVD process at a temperature in the range of 200-900°C and a pressure in the range of 0.1 Torr to 760 Torr with any of the following precursor gases:

$$M(N(CH_3)_2)_4 + Si(N(CH_3)_2)_4 + RG = M\text{-}SiON$$

$$M(N(C_2H_5)_2)_4 + Si(N(CH_3)_2)_4 + RG = M\text{-}SiON$$

$$M(N(C_2H_5)_2)_4 + Si(N(C_2H_5)_2)_4 + RG = M\text{-}SiON$$

$$M(N(CH_3)_2)_4 + Si(N(C_2H_5)_2)_4 + RG = M\text{-}SiON$$

$$M(i\text{-}O\text{-}Pr)_2(thd)_2 + DBDAS + RG = M\text{-}SiON$$

Where M = Hf, Zr, La, Y, etc,

$M(i\text{-}O\text{-}Pr)_2(thd)_2$ is bis(isopropoxy)bis(tetramethylheptanedionato) "metal", DBDAS is $[(CH_3)CO]\text{-}Si\text{-}[(O_2C(CH_3)]_2$ and

RG is a reactant gas or combination of reactant gases comprising $NH_3$, $N_2O$, NO or other nitriding gases in any relative ratio (e.g., 50% $NH_3$, 50% $N_2O$, and 0% NO).

Alternatively, the MSiON can be formed by using plasma enhanced CVD techniques to break down the metalorganic species and decrease the carbon content . There are many embodiments that one can generate using the plasma enhanced techniques.

Referring to FIG. 3, M-SiON gate dielectric 106 may be subjected to an oxidizing anneal. The purpose of the anneal is to adjust the nitrogen concentration and to anneal out defects. An oxidizing anneal increases the oxygen content and decreases the nitrogen content. In the preferred embodiment, a two-step anneal, such as that described in copending U.S. Patent Application Serial No. _____(TI-33776) filed _____, assigned to Texas Instruments Incorporated and incorporated herein by reference. The two-step anneal comprises a first high temperature anneal (e.g., 700-1100°C) in a non-oxidizing ambient (e.g., $N_2$) followed by a lower temperature anneal (e.g., <a maximum of 1100°C) in an oxidizing ambient (e.g., $O_2$, $N_2O$, NO, ozone, UV $O_2$, $H_2O_2$).

A MSiON formed by the above CVD process has several advantages. First, the interfacial oxide thickness is reduced versus a $MSiO_2$ deposition. In the example of FIG. 1, 9Å of interfacial oxide formed at the interface when a 36Å $HfSiO_2$ was formed. Incorporating nitrogen in the CVD process according to the invention decreases this interfacial oxide. Second, the addition of nitrogen further increases the dielectric constant. Finally, dopant penetration is decreased because of the presence of nitrogen and thermal stability is increased.

After the anneal, a gate electrode material 110 is deposited over the high-k gate dielectric 106, as shown in FIG 4. Processing then continues by patterning and etching to form the gate electrode, forming the source/drain junction regions, forming interconnects and packaging the device.

A second embodiment of the invention will now be described in conjunction with a method for forming a MOSFET transistor. As in the first embodiment, a semiconductor body 100 is processed through the formation of isolation structures 102 and any desired channel or threshold adjust implants. Semiconductor body 102 typically comprises a silicon substrate with or without additional epitaxial layers formed thereon as is known in the art.

The surface 104 of semiconductor body 100 is preferably a clean, oxide free surface. In addition, the surface 104 may be hydrogen terminated. Methods for providing such a surface are known in the art. U.S. Patent No. 6,291,867, issued 9/18/01 assigned to Texas Instruments Incorporated and incorporated herein by reference describes several methods for providing such a surface.

A MSiN gate dielectric 108 is deposited by CVD on the surface of semiconductor body 102, as shown in FIG. 5. MSiN gate dielectric 108 may, for example, comprise HfSiN, ZrSiN, LaSiN, YSiN, GdSiN, EuSiN, or PrSiN. Including nitrogen in the CVD deposition prevents or at least minimizes the formation of an interfacial oxide. The MSiN film 108 can be deposited using a number of precursors such as amido precursors [Tetrakis(dimethylamido)silicon, Tetrakis(diethylamido) silicon, Tetrakis(dimethylamido)hafnium - or other metal, and Tetrakis(diethylamido)hafnium - or other metal], beta diketontates, tertiary butoxide metal precursors, etc.

Alternatively, the MSiN can be formed by using plasma enhanced CVD techniques to break down the metalorganic species and decrease the carbon content . There are many embodiments that one can generate using the plasma enhanced techniques.

Referring to FIG. 6, M-SiN gate dielectric 108 is subjected to an oxidizing anneal to form M-SiON 106. The purpose of the anneal is to adjust the nitrogen concentration, to anneal out defects, and incorporate oxygen. As described above, a two-step anneal sequence may be used.

After the anneal, a gate electrode material 110 is deposited over the high-k gate dielectric 106, as shown in FIG 4. Processing then continues by patterning and etching to form the gate electrode, forming the source/drain junction regions, forming interconnects and packaging the device.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

**Claims**

1. A method for fabricating an integrated circuit, comprising the steps of:

   providing a partially fabricated semiconductor body; and
   forming a gate dielectric by depositing a high-k film comprising metal, silicon, and nitrogen by chemical vapor deposition on a surface of a semiconductor body.

**2.** The method of claim 1, wherein said high-k film comprises a metal-silicon-oxynitride.

**3.** The method of claim 1, wherein said high-k film comprises a material selected from the group consisting of HfSiN, HfSiON, ZrSiN, ZrSiON, LaSiN, LaSiON, YSiN, YSiON, GdSiN, GdSiON, EuSiN, EuSiON, PrSiN, and PrSiON.

**4.** The method of any preceding claim, wherein said chemical vapor deposition step occurs at a temperature in the range of 200°C to 900°C and a pressure in the range of 0.1 Torr to 760 Torr.

**5.** The method of any preceding claim further comprising the step of annealing the high-k film to control the nitrogen concentration and vacancies within the high-k film.

**6.** The method of claim 5, wherein said annealing step comprises:

a first higher temperature anneal in a non-oxidizing ambient; and
a second lower temperature anneal in an oxidizing ambient, wherein said lower temperature is lower than said higher temperature.

**7.** A method for fabricating an integrated circuit, comprising the steps of:

providing a partially fabricated semiconductor body; and
forming a gate dielectric by:

chemical vapor deposition of a high-k film comprising metal, silicon, and nitrogen a surface of a semiconductor body using a silicon precursor selected from the group consisting of tetrakis(dimethylamido)silicon and tetrakis(diethylamido)silicon, a metal precursor selected from the group consisting of tetrakis(dimethylamido)metal and tetrakis(diethylamido)metal, where metal is Hf, Zr, La, Y, Gd, Eu, or Pr; and a nitrogen-containing precursor.

**8.** The method of claim 7, wherein said high-k film comprises a metal-silicon-oxynitride and the chemical vapor deposition step further comprises using an oxygen precursor.

**9.** The method of claim 7 or claim 8, further comprising the step of annealing the high-k film to control the nitrogen concentration.

**10.** The method of claim 9, wherein said annealing step comprises:

a first higher temperature anneal in a non-oxidizing ambient; and
a second lower temperature anneal in an oxidizing ambient, wherein said lower temperature is lower than said higher temperature.

FIG. 1
(PRIOR ART)

FIG. 2

FIG. 3

FIG. 4

FIG. 5

FIG. 6